# EUROPEAN PATENT APPLICATION

(11) **EP 4 418 430 A1**
(43) Date of publication of application: **21.08.2024**
(21) Application number: 22885882.5
(22) Date of filing: 24.10.2022
(51) Int. Cl.: H01M 50/298, H01M 50/569, H01M 50/24

(54) **BATTERY PACK, BATTERY PACK BOX BODY GROUP, ELECTRICAL APPARATUS, AND ELECTRICITY STORAGE CABINET**

(30) Priority: 01.11.2021 CN 202122648985 U
(71) Applicant: Contemporary Amperex Technology Co., Limited, Ningde, Fujian 352100 (CN)
(72) Inventor: PAN, Xin, Ningde, Fujian 352100 (CN); CHEN, Zhiming, Ningde, Fujian 352100 (CN)
(74) Representative: Gong, Jinping
(86) International application number: PCT/CN2022/127137
(87) International publication number: WO 2023/072005

(57) **Abstract**

The present application discloses a battery pack, a battery pack box group, an electrical apparatus, and an electricity storage cabinet. The battery pack includes a battery box, a battery module, a sampling wire and a low-voltage connector; the battery box is provided with an accommodating space for accommodating the battery module and a box sealing structure; the battery module is provided with a battery positive terminal post and a battery negative terminal post; and the battery positive terminal post and the battery negative terminal post of the battery module are connected with the low-voltage connector through the sampling wire for sampling the battery pack. The embodiment of the present application can increase a rotation speed of a wiping apparatus to improve cleaning efficiency, and can prevent a cleaning belt from cross-contaminating a battery.

## Description

The present application claims the priority of the Chinese patent application No. 202122648985.7 entitled "BATTERY PACK, BATTERY PACK BOX GROUP, ELECTRICAL APPARATUS, AND ELECTRICITY STORAGE CABINET" and filed on November 01, 2021, of which the entire contents are incorporated herein by reference.

### TECHNICAL FIELD

The present application relates to the technical field of battery packs, in particular to a battery pack, a battery pack box group, an electrical apparatus, and an electricity storage cabinet.

### BACKGROUND

At present, the country is vigorously developing a new energy vehicle, and the use of a new energy power battery is increasing. Moreover, in the relevant art, the new energy power battery mostly integrates a cell into a module, and then integrates the module into a battery pack to form a module-integrated battery pack. However, this traditional module-integrated battery pack has low grouping efficiency, complex structure, low integration, high cost, and complex production and processing.

In some cases, a low-voltage sampling structure of the battery pack is arranged above the cell, which occupies an installation space of the battery pack and reduces grouping efficiency of the battery pack. In addition, installing above the battery pack requires the addition of various insulations and protections and results in a complex battery pack structure.

### SUMMARY OF THE INVENTION

### Technical Problem

In view of the above problems, the present application provides a battery pack, a battery pack box group, an electrical apparatus and an electricity storage cabinet, which can save an installation space of a sampling structure, improve integration of a battery pack sampling device, reduce insulation and protection parts, improve grouping efficiency, and meanwhile improve waterproof performance of an integrated low-voltage battery pack battery box.

### Technical Solution

In a first aspect, the present application provides a battery pack, including a battery box, a battery module, a sampling wire and a low-voltage connector; the battery box is provided with an accommodating space for accommodating the battery module and a box sealing structure; the battery module is provided with a battery positive terminal post and a battery negative terminal post; and the battery positive terminal post and the battery negative terminal post of the battery module are connected with the low-voltage connector through the sampling wire for sampling the battery pack.

In some embodiments, the battery pack further includes a box cover; and the box sealing structure is arranged on an inner side of an upper opening of the battery box, and the box cover is installed on the battery box through the box sealing structure. The box cover and the battery box are sealed by the box sealing structure. In some embodiments, the box sealing structure includes a sealing strip and a U-shaped sealing groove; the sealing strip is arranged on an inner wall of the U-shaped sealing groove; a side surface of the box cover extends toward a side surface of the battery box to be provided with an extension portion; and the extension portion is inserted into the U-shaped sealing groove and fits with the sealing strip. A sealed installation effect is achieved by inserting the extension portion of the box cover into the box sealing structure at the inner side of the upper opening of the battery box.

In some embodiments, the battery module, the sampling wire, the low-voltage connector, the battery positive terminal post and the battery negative terminal post are all integrated into the battery box to form a modular integrated control unit together with the battery box.

In some embodiments, the integrated control unit is in plug connection with the battery positive terminal post and the battery negative terminal post of the battery module respectively through the sampling wire, the battery positive terminal post and the battery negative terminal post which are exposed in the battery box serve as energy output ends of the entire battery pack, and the low-voltage connector arranged on an side wall of the battery box serves as a data output end.

In some embodiments, the sealing strip is attached tightly to a side wall of the extension portion and an inner wall of the U-shaped sealing groove. In the box body of the embodiment of the present application, the sealing strip is attached to the inner wall of the U-shaped sealing groove, and when the extension portion is inserted into the U-shaped sealing groove, the extension portion is also tightly attached to the sealing strip.

In some embodiments, a height of the inner wall of the U-shaped sealing groove is lower than a height of an outer wall of the U-shaped sealing groove. In the box of the embodiment of the present application, when the height of the inner wall of the U-shaped sealing groove is lower than the height of the outer wall of the U-shaped sealing groove, it may play a supporting role for the box cover.

In some embodiments, the height of the outer wall of the U-shaped sealing groove is lower than a height of the extension portion. In the box of the embodiment of the present application, when the height of the outer wall of the U-shaped sealing groove is lower than the height of the extension portion, an inner side of the box cover may be in contact with the inner wall of the U-shaped sealing groove to enhance a sealing effect.

In a second aspect, the present application provides a battery pack box group, composed of any of the battery packs of the above solutions.

In a third aspect, the present application provides an electrical apparatus, the electrical apparatus includes a battery pack box group, and the battery pack box group is used for providing electric energy for the electrical apparatus.

In a fourth aspect, the present application provides an electricity storage cabinet, the electricity storage cabinet includes a battery pack box group, and the battery pack box group is used for providing electric energy for the electricity storage cabinet.

By adopting the above technical solutions, the beneficial effects of the present application are as follows: the sampling wire of the present application is directly integrated into the battery box by injection molding, the battery module is inverted in the box, the battery module and the sampling wire are directly installed on the low-voltage connector through installation holes, and the low-voltage connector is arranged on the side wall of the battery box, thereby realizing a function of battery pack sampling, saving the installation space of the sampling structure, reducing the insulation and protection parts, and improving the grouping efficiency. A vertical sealing structure is arranged between an upper cover and the box to effectively prevent moisture, water vapor, and the like from entering the battery pack box; and by filling the U-shaped sealing groove with the sealing strip, it may be ensured that all gaps may be filled, thereby achieving the sealing effect.

The above description is only a summary of the technical solutions of the present application. In order to be able to understand the technical means of the present application more clearly, and the technical means can be implemented according to the content of the specification, furthermore, in order to make the above and other objectives, features and advantages of the present application more obvious and understandable, specific implementations of the present application are exemplified below.

### Beneficial Effects

In the technical solutions of the embodiments of the present application, the battery module is accommodated in the accommodating space of the battery box, the battery pack is sealed by the box sealing structure on the battery box, and the battery positive terminal post and the battery negative terminal post on the battery module are connected with the low-voltage connector through the sampling wire for sampling the battery pack.

### DESCRIPTION OF DRAWINGS

Various other advantages and benefits will become apparent to those of ordinary skill in the art upon reading the following detailed description of the optional implementations. The accompanying drawings are for the purpose of illustrating the optional implementations only and are not to be considered a limitation to the present application. Moreover, in all of the accompanying drawings, the same components are indicated by the same reference numerals. In the figures:
Fig. 1 is a schematic structural diagram of a battery pack in some embodiments of the present application.
Fig. 2 is a sectional view of a battery pack in some embodiments of the present application.
Fig. 3 is a partial enlarged view of a part A in Fig. 2.
Fig. 4 is a structural block diagram of an integrated control unit of a battery pack in some embodiments of the present application.
Fig. 5 is a schematic structural diagram of a battery pack box group in some embodiments of the present application.
Fig. 6 is a schematic structural diagram of an electrical apparatus in some embodiments of the present application.
Fig. 7 is a schematic structural diagram of an electricity storage cabinet in some embodiments of the present application.

Reference numerals in Detailed Description are as follows:
Battery box 1;
U-shaped sealing groove 101, Sealing strip 102;
Box cover 2;
Extension portion 201;
Battery module 3;
Battery positive terminal post 301, Battery negative terminal post 302;
Sampling wire 4;
Low-voltage connector 5;
Battery pack box group 6; battery pack 61;
Electrical apparatus 7; and
Electricity storage cabinet 8.

### DETAILED DESCRIPTION

Embodiments of the technical solutions of the present application will be described in detail below with reference to the accompanying drawings. The following embodiments are only used to more clearly illustrate the technical solutions of the present application, and therefore are only used as examples and cannot be used to limit the scope of protection of the present application.

Unless otherwise defined, all technical and scientific terms used in the present application have the same meanings as those commonly understood by those skilled in the art belonging to the technical field of the present application. The terms used in the present application are only for the purpose of describing specific embodiments, but are not intended to limit the present application. The terms "comprising" and "having" and any variations thereof in the specification and the claims of the present application as well as the foregoing description of the accompanying drawings are intended to cover non-exclusive inclusions.

In the description of the embodiments of the present application, the technical terms "first", "second", and the like are used only to distinguish between different objects, and cannot be understood as indicating or implying a relative importance or implicitly specifying the number, particular order, or primary and secondary relation of the technical features indicated. In the description of the embodiments of the present application, the meaning of "a plurality of" is two or more, unless otherwise explicitly and specifically defined.

The phrase "embodiment" referred to in the present application means that the descriptions of specific features, structures, and characteristics in combination with the embodiment are included in at least one embodiment of the present application. The appearance of this phrase in various places in the specification does not necessarily refer to the same embodiment, nor is it a separate or alternative embodiment that is mutually exclusive with other embodiments. It is understood explicitly and implicitly by those skilled in the art that the embodiments described in the present application can be combined with other embodiments.

In the description of the embodiments of the present application, a term "and/or" is simply a description of an association relationship of associated objects, and indicates that there may be three relationships, for example, A and/or B may represent three situations: A exists alone, both A and B exist, and B exists alone. In addition, a character "/" in the present application generally indicates that the previous and next association objects are in an "or" relationship.

In the description of the embodiments of the present application, the term "a plurality of" refers to two or more (including two). Similarly, "a plurality of groups" refers to two or more (including two) groups, and "a plurality of sheets" refers to two or more (including two) sheets.

In the descriptions of the embodiments of present application, orientations or positional relationships indicated by the technical terms "center", "longitudinal", "transverse", "length", "width", "thickness", "upper", "lower", "front", "rear", "left", "right", "vertical", "horizontal", "top", "bottom", "inner", "outer", "clockwise", "anticlockwise", "axial", "radial", "circumferential" and the like are orientations or positional relationships shown on the basis of the accompanying drawings, and are only for the purpose of facilitating and simplifying the descriptions of the embodiments of the present application, instead of indicating or implying that devices or elements indicated must have particular orientations, and be constructed and operated in the particular orientations, so that these terms are not construed as limiting the embodiments of the present application.

In the description of the embodiments of the present application, unless otherwise expressly specified and defined, the technical terms "install", "connect", "link", "fix" and the like should be understood in a broad sense, such as, a fixed connection, a detachable connection, or an integral connection; a mechanical connection, or an electrical connection; a direct connection, an indirect connection through an intermediate medium, internal communication between two elements, or interaction between two elements. Those ordinarily skilled in the art may understand the specific meanings of the above terms in the embodiments of the present application according to the specific situations.

At present, from the development of a market situation, the country is vigorously developing new energy vehicles, and the use of new energy power batteries is increasing. In some cases, a low-voltage sampling structure of a battery pack is arranged above a cell, which occupies an installation space of the battery pack and reduces grouping efficiency of the battery pack. In addition, installing above the battery pack requires the addition of various insulations and protections and results in a complex battery pack structure. Moreover, in the related art, a new energy power battery mostly integrates a cell into a module, and then integrates the module into the battery pack to form a module-integrated battery pack. However, this traditional module-integrated battery pack has low grouping efficiency, complex structure, low integration, high cost, and complex production and processing.

In some cases, a power battery pack is not assembled in a modular manner, and battery parts are installed individually in a box. This is especially true for a low-voltage battery pack. Due to a small space in the box, there is interference between a tool and the box during installation. At the same time, in some cases, the manufacture of the battery pack cannot be assembled in an assembly line manner, and can only be assembled by one person inside the box, resulting in low assembly efficiency. In some cases, electrical apparatus control systems of the battery pack is not integrated and modularized, and are installed inside the box separately, and corresponding structures need to be designed on the box to facilitate installation, which makes the box structure complex, occupies a large space, and increases an overall weight, resulting in lowering of a gravimetric specific energy density and a volumetric specific energy density of the battery pack. At the same time, in some cases, the battery pack needs to have installing holes on the box for installing a low-voltage connector and the like, which increases the design difficulty and reduces sealing performance of the battery pack.

The applicant has noticed that a battery pack sampling device is not sufficiently integrated and has low grouping efficiency.

In order to solve a problem of how to save an installation space of a sampling structure, improve the integration of a battery pack sampling device, reduce insulation and protection parts, improve grouping efficiency, and improve waterproof performance of an integrated low-voltage battery pack battery box, the applicant found through researches that a battery pack, a battery pack box group, an electrical apparatus, and an electricity storage cabinet may be proposed.

Based on the above considerations, the applicant has conducted in-depth research and designed a battery pack 61, including a battery box 1, a battery module 3, a sampling wire 4, and a low-voltage connector 5. The battery box 1 is provided with an accommodating space for accommodating the battery module 3 and a box sealing structure; the battery module 3 is provided with a battery positive terminal post 301 and a battery negative terminal post 302; and the battery positive terminal post 301 and the battery negative terminal post 302 of the battery module 3 are connected with the low-voltage connector 5 through the sampling wire 4 for sampling the battery pack 61.

In the technical solutions of the embodiment of the present application, the battery module 3 is accommodated in the accommodating space of the battery box 1, the battery pack 61 is sealed by the box sealing structure on the battery box 1, and the battery positive terminal post 301 and the battery negative terminal post 302 on the battery module 3 are connected with the low-voltage connector 5 through the sampling wire 4 for sampling the battery pack 61.

For ease of description, the following embodiments are illustrated by using a battery pack 61 in an embodiment of the present application.

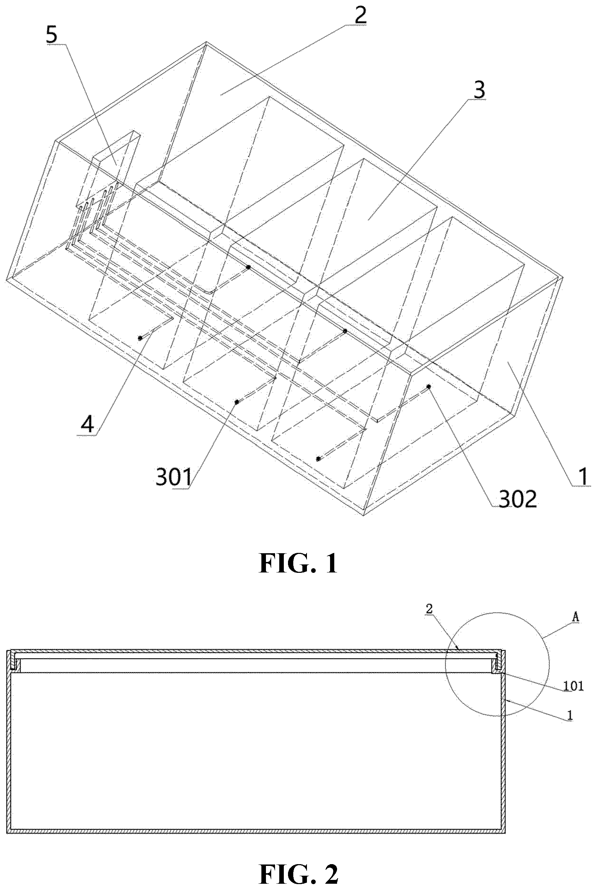

According to some embodiments of the present application, Fig. 1 is a schematic structural diagram of a battery pack 61 in some embodiments of the present application.

The present application provides a battery pack 61, including a battery box 1, a battery module 3, a sampling wire 4, and a low-voltage connector 5. The battery box 1 is provided with an accommodating space for accommodating the battery module 3 and a box sealing structure; the battery module 3 is provided with a battery positive terminal post 301 and a battery negative terminal post 302; and the battery positive terminal post 301 and the battery negative terminal post 302 of the battery module 3 are connected with the low-voltage connector 5 through the sampling wire 4 for sampling the battery pack 61.

In the technical solutions of the embodiment of the present application, the battery module 3 is accommodated in the accommodating space of the battery box 1, the battery pack 61 is sealed by the box sealing structure on the battery box 1, and the battery positive terminal post 301 and the battery negative terminal post 302 on the battery module 3 are connected with the low-voltage connector 5 through the sampling wire 4 for sampling the battery pack 61.

According to some embodiments of the present application, optionally, the battery pack 61 further includes a box cover 2; and the box sealing structure is arranged on an inner side of an upper opening of the battery box 1, and the box cover 2 is installed on the battery box 1 through the box sealing structure.

According to some embodiments of the present application, optionally, the box sealing structure includes a sealing strip 102 and a U-shaped sealing groove 101; the sealing strip 102 is arranged on an inner wall of the U-shaped sealing groove 101; a side surface of the box cover 2 extends toward a side surface of the battery box 1 to be provided with an extension portion 201; and the extension portion 201 is inserted into the U-shaped sealing groove 101 and fits with the sealing strip 102. A sealed installation effect is achieved by inserting the extension portion 201 of the box cover 2 into the box sealing structure at the inner side of the upper opening of the battery box 1. The box sealing structure is arranged between the box cover 2 of the present application and the battery box 1 to effectively prevent moisture, water vapor, and the like from entering the battery pack box; and by filling the U-shaped sealing groove with the sealing strip, it may be ensured that all gaps may be filled, thereby achieving a sealing effect.

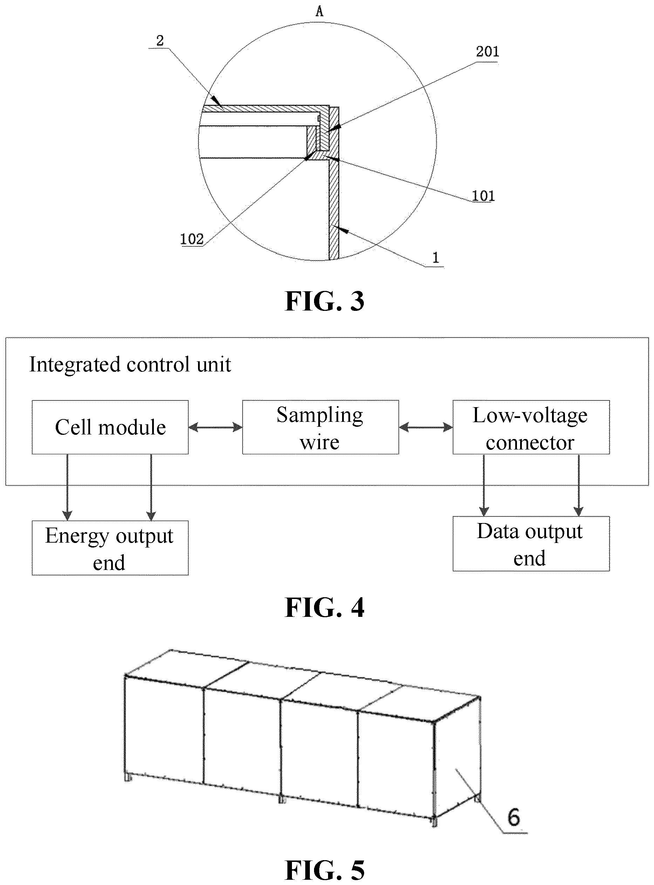

Referring to Fig.2 and Fig. 3, Fig. 2 is a sectional view of the battery pack 61 in some embodiments of the present application, and Fig. 3 is a partial enlarged view of a part A in Fig. 2.

According to some embodiments of the present application, optionally, the battery module 3, the sampling wire 4, the low-voltage connector 5, the battery positive terminal post 301 and the battery negative terminal post 302 are all integrated into the battery box 1 to form a modular integrated control unit together with the battery box 1. The integrated control unit is in plug connection with the battery positive terminal post and the battery negative terminal post of the battery module 3 respectively through the sampling wire 4, the battery positive terminal post 301 and the battery negative terminal post 302 which are exposed in the battery box 1 serve as energy output ends of the entire battery pack 61, and the low-voltage connector 5 arranged on an side wall of the battery box 1 serves as a data output end.

Please refer to Fig. 4, and Fig. 4 is a structural block diagram of the integrated control unit of the battery pack 61 in some embodiments of the present application.

According to some embodiments of the present application, optionally, the sealing strip 102 is attached tightly to a side wall of the extension portion 201 and an inner wall of the U-shaped sealing groove 101. In some embodiments of the present application, the sealing strip 102 is attached to the inner wall of the U-shaped sealing groove 101, and when the extension portion 201 is inserted into the U-shaped sealing groove 101, the extension portion is also tightly attached to the sealing strip 102.

According to some embodiments of the present application, optionally, a height of the inner wall of the U-shaped sealing groove 101 is lower than a height of an outer wall of the U-shaped sealing groove 101. In some embodiments of the present application, when the height of the inner wall of the U-shaped sealing groove 101 is lower than the height of the outer wall of the U-shaped sealing groove 101, it may play a supporting role for an upper cover 2.

According to some embodiments of the present application, optionally, the height of the outer wall of the U-shaped sealing groove 101 is lower than a height of the extension portion 201. In some embodiments of the present application, when the height of the outer wall of the U-shaped sealing groove 101 is lower than the height of the extension portion 201, an inner side of the upper cover 2 may be in contact with the inner wall of the U-shaped sealing groove 101 to enhance a sealing effect.

The sampling wire 4 of the present application is directly integrated into the battery box 1 by injection molding, the battery module 3 is inverted in the box, the battery module and the sampling wire 4 are directly installed on the low-voltage connector through installation holes, and the low-voltage connector is arranged on the side wall of the battery box 1, thereby realizing a function of sampling the battery pack 61, saving the installation space of the sampling structure, reducing the insulation and protection parts, and improving the grouping efficiency. A vertical sealing structure is arranged between the upper cover and the box to effectively prevent the moisture, the water vapor, and the like from entering the battery pack box; and by filling the U-shaped sealing groove with the sealing strip, it may be ensured that all gaps may be filled, thereby achieving the sealing effect.

The battery pack 61 disclosed in the embodiment of the present application may be used, but not limited to, in an electrical apparatus such as a vehicle, a ship, or an aircraft. A power source system of the electrical apparatus may be composed of the battery pack 61 and the like disclosed in the present application, which is beneficial to alleviating and automatically adjusting deterioration of cell expansion force, supplementing electrolyte consumption, and improving the stability of battery performance and prolonging a battery life.

Referring to Fig. 5, Fig. 5 is a schematic structural diagram of a battery pack box group in some embodiments of the present application.

According to some embodiments of the present application, the present application further provides a battery pack box group, and the battery pack box group 6 is composed of the battery pack 61 in any embodiment above.

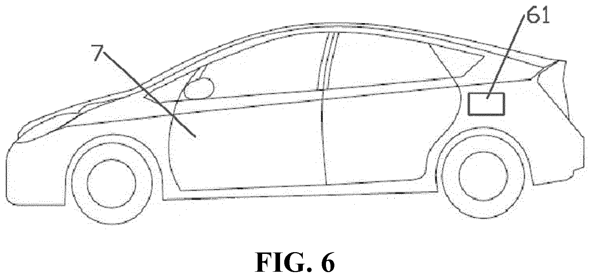

Referring to Fig. 6, Fig. 6 is a schematic structural diagram of an electrical apparatus in some embodiments of the present application.

According to some embodiments of the present application, the present application further provides an electrical apparatus, the electrical apparatus 7 includes a battery pack box group 6, the battery pack box group 6 is used for providing electric energy to the electrical apparatus 7, a battery is used for providing electric energy, and a sampling wire 4 samples the electricity consumption of the electrical apparatus.

An embodiment of the present application provides an electrical apparatus using a battery as a power source. The electrical apparatus may be, but is not limited to, a mobile phone, a tablet computer, a notebook computer, an electric toy, an electric tool, a battery car, an electric vehicle, a ship, a spacecraft, and the like. The electric toy may include a stationary or mobile electric toy, such as a game machine, an electric car toy, an electric ship toy, or an electric airplane toy, and the spacecraft may include an airplane, a rocket, an aerospace plane, a spaceship, and the like.

In some embodiments of the present application, the electrical apparatus 7 may be a fuel vehicle, a gas vehicle, or a new energy vehicle, and the new energy vehicle may be an battery electric vehicle, a hybrid electric vehicle, an extended range electric vehicle, etc. A battery pack 6 is arranged inside the electrical apparatus 7. The battery pack 6 may be used for power supplying of the electrical apparatus 7, for example, the battery pack 61 may serve as an operating power source of the electrical apparatus 7. The electrical apparatus 7 may further include a controller and a motor. The controller is used for controlling the battery pack 61 to power the motor, for example, for meeting operating power requirements of starting, navigating, and driving of the electrical apparatus 7.

In some embodiments of the present application, the battery pack 61 may not only serve as the operating power source of the electrical apparatus 7, but also serve as a driving power source of the electrical apparatus 7 to replace or partially replace fuel or natural gas to provide driving power for the electrical apparatus.

The battery pack 61 may be applied to a variety of electrical devices. After being placed in a battery pack box, a battery may be used in various scenarios such as moisture, water accumulation, and severe corrosion. The battery pack box of the battery pack 61 ensures that the internal battery pack 61 is not damaged.

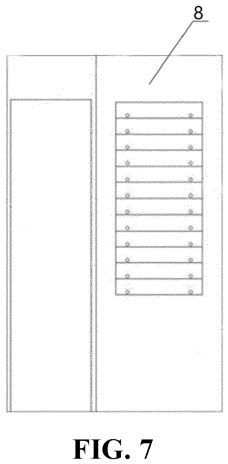

Referring to Fig. 7, Fig. 7 is a schematic structural diagram of an electricity storage cabinet in some embodiments of the present application.

According to some embodiments of the present application, the present application further provides an electricity storage cabinet. The electricity storage cabinet 8 includes a battery pack box group 6, and the battery pack box group 6 is used for providing electric energy for the electricity storage cabinet 8.

According to some embodiments of the present application, please refer to Fig. 1 to Fig. 4 again. Fig. 1 is a schematic structural diagram of a battery pack 61 in some embodiments of the present application. Fig. 2 is a sectional view of the battery pack 61 in some embodiments of the present application. Fig. 3 is a partial enlarged view of a part A in Fig. 2. Fig. 4 is a structural block diagram of an integrated control unit of the battery pack 61 in some embodiments of the present application.

The present application provides a battery pack 61, including a battery box 1, a battery module 3, a sampling wire 4, and a low-voltage connector 5. The battery box 1 is provided with an accommodating space and a box sealing structure; the battery module 3 is accommodated in the accommodating space of the battery box 1, the battery module 3 is provided with a battery positive terminal post and a battery negative terminal post, which form a battery positive terminal post 301 and a battery negative terminal post 302; and the battery positive terminal post and the battery negative terminal post of the battery module 3 are connected with the low-voltage connector 5 through the sampling wire 4 for sampling the battery pack 61. The battery module 3 is accommodated in the accommodating space of the battery box 1, the battery pack 61 is sealed by the box sealing structure on the battery box 1, and the battery positive terminal post 301 and the battery negative terminal post 302 on the battery module 3 are connected with the low-voltage connector 5 through the sampling wire 4 for sampling the battery pack 61. The battery pack 61 further includes a box cover 2; and the box sealing structure is arranged on an inner side of an upper opening of the battery box 1, and the box cover 2 is installed on the battery box 1 through the box sealing structure. The box sealing structure includes a sealing strip 102 and a U-shaped sealing groove 101; the sealing strip 102 is arranged on an inner wall of the U-shaped sealing groove 101; a side surface of the box cover 2 extends toward a side surface of the battery box 1 to be provided with an extension portion 201; and the extension portion 201 is inserted into the U-shaped sealing groove 101 and fits with the sealing strip 102. The battery module 3, the sampling wire 4, the low-voltage connector 5, the battery positive terminal post 301 and the battery negative terminal post 302 are all integrated into the battery box 1 to form a modular integrated control unit together with the battery box 1. The integrated control unit is in plug connection with the battery positive terminal post and the battery negative terminal post of the battery module 3 respectively through the sampling wire 4, the battery positive terminal post 301 and the battery negative terminal post 302 which are exposed in the battery box 1 serve as energy output ends of the entire battery pack 61, and the low-voltage connector 5 arranged on an side wall of the battery box 1 serves as a data output end. In some embodiments of the present application, the sealing strip 102 is attached tightly to a side wall of the extension portion 201 and an inner wall of the U-shaped sealing groove 101. The sealing strip 102 is attached to the inner wall of the U-shaped sealing groove 101, and when the extension portion 201 is inserted into the U-shaped sealing groove 101, the extension portion is also tightly attached to the sealing strip 102. A height of the inner wall of the U-shaped sealing groove 101 is lower than a height of an outer wall of the U-shaped sealing groove 101. The height of the outer wall of the U-shaped sealing groove 101 is lower than a height of the extension portion 201. When the height of the outer wall of the U-shaped sealing groove 101 is lower than the height of the extension portion 201, an inner side of the upper cover 2 may be in contact with the inner wall of the U-shaped sealing groove 101 to enhance a sealing effect.

The sampling wire 4 of the present application is directly integrated into the battery box 1 by injection molding, the battery module 3 is inverted in the box, the battery module and the sampling wire 4 are directly installed on the low-voltage connector through installation holes, and the low-voltage connector is arranged on the side wall of the battery box 1, thereby realizing a function of sampling the battery pack 61, saving the installation space of the sampling structure, reducing the insulation and protection parts, and improving the grouping efficiency. A vertical sealing structure is arranged between the upper cover and the box to effectively prevent the moisture, the water vapor, and the like from entering the battery pack box; and by filling the U-shaped sealing groove with the sealing strip, it may be ensured that all gaps may be filled, thereby achieving the sealing effect.

Finally, it should be noted that: the above embodiments are merely used to illustrate the technical solutions of the present application, instead of imposing any limitation on the present application. Although the present application has been described in detail with reference to the aforementioned embodiments, those ordinarily skilled in the art should understand that they can still modify the technical solutions recorded in all the aforementioned embodiments, or equivalently replace part or all of the technical features thereinto. These modifications and replacements are not intended to make the essence of corresponding technical solutions depart from the scope of the technical solutions of the embodiments of the present application, and should be encompassed within the scope of the claims and specification of the present application. In particular, the technical features mentioned in the various embodiments can be combined in any manner as long as there is no structural conflict. The present application is not limited to the specific embodiments disclosed herein, but rather includes all technical solutions falling within the scope of the claims.

## Claims

1. A battery pack, comprising a battery box (1), a battery module (3), a sampling wire (4) and a low-voltage connector (5), wherein
the battery box (1) is provided with an accommodating space for accommodating the battery module (3) and a box sealing structure, and the battery module (3) is provided with a battery positive terminal post (301) and a battery negative terminal post (302); and
the battery positive terminal post (301) and the battery negative terminal post (302) of the battery module (3) are connected with the low-voltage connector (5) through the sampling wire (4) for sampling the battery pack.

2. The battery pack according to claim 1, further comprising a box cover (2), wherein the box sealing structure is arranged on an inner side of an upper opening of the battery box (1), and the box cover (2) is installed on the battery box (1) through the box sealing structure.

3. The battery pack according to claim 2, wherein the box sealing structure comprises a sealing strip (102) and a U-shaped sealing groove (101); and
the sealing strip (102) is arranged on an inner wall of the U-shaped sealing groove (101).

4. The battery pack according to claim 3, wherein a side surface of the box cover (2) extends toward a side surface of the battery box (1) to be provided with an extension portion (201); and
the extension portion (201) is inserted into the U-shaped sealing groove (101) and fits with the sealing strip (102).

5. The battery pack according to claim 4, wherein the sealing strip (102) is attached tightly to a side wall of the extension portion (201) and an inner wall of the U-shaped sealing groove (101).

6. The battery pack according to claim 4 or 5, wherein a height of an inner wall of the U-shaped sealing groove (101) is lower than a height of an outer wall of the U-shaped sealing groove (101).

7. The battery pack according to any one of claims 4 to 6, wherein a height of an outer wall of the U-shaped sealing groove (101) is lower than a height of the extension portion (201).

8. The battery pack according to any one of claims 1 to 7, wherein the battery module (3), the sampling wire (4), the low-voltage connector (5), the battery positive terminal post (301) and the battery negative terminal post (302) are all integrated in the battery box (1) and form a modular integrated control unit together with the battery box (1).

9. The battery pack according to claim 8, wherein the integrated control unit is in plug connection with the battery positive terminal post (301) and the battery negative terminal post (302) of the battery module (3) respectively through the sampling wire (4).

10. The battery pack according to claim 8 or 9, wherein the battery positive terminal post (301) and the battery negative terminal post (302) which are exposed in the battery box (1) serve as energy output ends of the entire battery pack, and the low-voltage connector (5) arranged on the side wall of the battery box (1) serves as a data output end.

11. A battery pack box group, wherein the battery pack box group (6) is composed of the battery pack according to any one of claims 1 to 10.

12. An electrical apparatus, comprising the battery pack box group according to claim 11, wherein the battery pack box group (6) is used for providing electric energy for the electrical apparatus (7).

13. An electricity storage cabinet, comprising the battery pack box group according to claim 11, wherein the battery pack box group (6) is used for providing electric energy for the electricity storage cabinet (8).
